# EUROPÄISCHE PATENTSCHRIFT

(11) **EP 3 221 646 B1**
(45) Veröffentlichungstag und Bekanntmachung des Hinweises auf die Patenterteilung: **02.01.2019**
(21) Anmeldenummer: 15804083.2
(22) Anmeldetag: 17.11.2015
(51) Int. Cl.: F24F 1/00, F24F 7/04, F24F 7/10, H05K 7/20, F24F 7/013

(54) **VERFAHREN UND ANORDNUNG ZUM KLIMATISIEREN EINES KALTGANGES**
METHOD AND ARRANGEMENT FOR AIR-CONDITIONING A COLD AISLE
PROCÉDÉ ET SYSTÈME DE CLIMATISATION D'UNE ALLÉE FROIDE

(30) Priorität: 17.11.2014 DE 102014116792
(43) Veröffentlichungstag der Anmeldung: 27.09.2017
(73) Patentinhaber: Weiss Klimatechnik GmbH, 35447 Reiskirchen-Lindenstruth (DE)
(72) Erfinder: KÖSTER, Mathias, 61231 Bad Nauheim (DE); SALOMON, Peter, 74915 Waibstadt (DE)
(74) Vertreter: Stoffregen, Hans-Herbert
(86) Internationale Anmeldenummer: PCT/EP2015/076827
(87) Internationale Veröffentlichungsnummer: WO 2016/079119

(56) Entgegenhaltungen:
- WO-A1-2013/150583
- DE-A1-102009 053 527
- GB-A- 2 510 750

## Beschreibung

Die Erfindung bezieht sich auf ein Verfahren zum Klimatisieren zumindest eines zumindest bereichsweise von wärmeerzeugenden Geräten begrenzten in einem Warmraum angeordneten Kaltgangs, wobei der Warmraum mittels einer Begrenzungswandung von einem zweiten Raum getrennt ist und zumindest ein Bereich der Begrenzungswandung durch zumindest einen Wärmetauscher bereichsweise als Kühlwand ausgebildet ist, und wobei über zumindest einen Ventilator über den zumindest einen Wärmetauscher geförderte Luft dem zumindest einen Kaltgang zugeführt wird.

Auch nimmt die Erfindung Bezug auf eine Anordnung zum Klimatisieren von zumindest einem in einem Warmraum angeordneten eingehausten Kaltgang, der strömungstechnisch über zumindest einen Ventilator mit einem durch zumindest eine bereichsweise als Kühlwand ausgebildete Begrenzungswandung von dem Warmraum begrenzten zweiten Raum verbunden ist, wobei der Ventilator druckseitig mit dem zumindest einen Kaltgang und saugseitig über zumindest einen einen Abschnitt der Begrenzungswandung bildenden Wärmetauscher mit dem Warmraum verbunden ist.

Um wärmeerzeugende Geräte zu kühlen, sind diese nach der DE 10 2009 053 527 A1 in einem Raum angeordnet, der einen Hohlboden aufweist. Zwischen dem Raum und einem zweiten Raum verläuft eine als Wärmetauscherfläche ausgebildete Wandung. Die erwärmte Luft wird aus dem Raum über den Hohlboden angesaugt, um über den Wärmetauscher dem Raum wieder zugeführt zu werden.

Die GB 2 510 750 A bezieht sich auf ein Rechenzentrum, das einen Warmraum mit in diesem verlaufenden Kaltgang umfasst. Der Warmraum ist über eine Trennwand von einem weiteren Raum getrennt, in dem Luft gekühlt wird oder gekühlte Luft zugeführt wird, die für den Kaltgang bestimmt ist.

Ein Rechenzentrum ist der WO 2013/150583 A zu entnehmen. Dieses weist einen in zumindest zwei Bereiche unterteilten Raum auf, dem über eine Öffnung Kühlluft zugeführt wird.

Der EP 2 278 231 A2 ist eine Anordnung zum Klimatisieren eines Raums zu entnehmen. Dabei ist ein Wärmetauscher als Raumbegrenzung bzw. Abschnitt einer Raumbegrenzung ausgebildet. Unterhalb des Raums befindet sich ein Hohlraum, durch den die mittels des Wärmetauschers gekühlte Luft dem Raum zugeführt wird. Auf diese Weise ist der Raum energetisch günstig zu kühlen. Gleichzeitig kann eine problemlose Wartung des Wärmetauschers erfolgen, da dieser auf einer Seite von dem wärmeerzeugende Geräte enthaltenden Raum und auf raumabgewandter Seite von einem Wartungsgang begrenzt ist.

Der DE 10 2009 030 214 A1 und der DE 200 23 882 U1 sind Klimatisierungsanordnungen zu entnehmen, bei denen über Öffnungen eines Hohlbodens Luft in einen zu klimatisierenden Raum strömt, um im reinen Umluftbetrieb in dem Raum vorhandene wärmeerzeugende Geräte zu kühlen.

Aus der US 6 672 955 B1 ist ein Rechenzentraum bekannt, in dem in Reihen angeordnete elektronische Geräte Warm- und Kaltgänge begrenzen. Die Kaltgänge sind eingehaust, um diesen über einen Zwischenboden gekühlte Luft zuzuführen. Die die elektrischen Geräte durchströmende Luft wird sodann im Deckenbereich abgesaugt, die anschließend einen Wärmetauscher durchsetzt, der von einem Kühlfluid durchströmt wird.

Um Rechner zu kühlen, werden diese nach der DE 20 2004 003 309 U1 in einem doppelwandigen zylinderförmig geformten Rechnergehäuse angeordnet, das Lufteinlassöffnungen aufweist, durch die Kühlluft hindurch strömt, um die Rechner zu kühlen. Die erwärmte Luft wird sodann über einen Luftkanal abgeführt, in dem ein Ventilator angeordnet ist. Die Abluft kann wahlweise als Fortluft abgeführt werden oder im Kreislauf strömen, um nach Durchströmen einer Kühleinrichtung dem Raum erneut zugeführt zu werden, in dem sich das Rechnergehäuse befindet.

Nach der EP 1 488 305 B1 wird in einem Schrank angeordneten wärmeerzeugenden Geräten gekühlte Luft zugeführt, die über einen in einem Klimagerät angeordneten Ventilator abgesaugt wird. Im Strömungsweg zum Ventilator ist in dem Klimagerät ein Wärmetauscher angeordnet.

Um einen Raum zu kühlen, in dem Rechner in Reihen angeordnet sind, sieht die DE 200 23 882 U1 einen in dem Raum angeordneten Klimaschrank und einen in einem Hohlbodenraum angeordneten Ventilator vor, über den die Abluft durch den Klimaschrank gesaugt wird, um sodann die Zuluft über eine Bodenöffnung dem Raum wieder zuzuführen.

Der DE 20 2004 003 309 U1 ist eine Cluster-Kühlung zu entnehmen, wobei Abluft aus einem von Rechnern umgebenen zylindrischen Raum wahlweise als Fortluft abgeführt oder einem Klimagerät zugeführt wird.

Gegenstand der WO 2006/124240 A1 ist eine Kühlanordnung für Rechner, wobei in einem Zwischenraum ein Wärmetauscher angeordnet ist.

Nach der US 2004/0099747 A1 ist in einem Rechnerraum ein gesondertes Klimagerät angeordnet.

Aus der DE 20 2009 002 033 A ist eine Anordnung zum Klimatisieren eines Raums bekannt. An einer Wand ist ein Klimagerät angeordnet, dem Außenluft und/oder Abluft zuführbar ist.

Gegenstand der DE 10 2011 117 908 B4 ist eine Kühlanordnung zum Kühlen von in einem Raum in Schaltschränken angeordneten elektronischen Geräten. In dem die Geräte enthaltenden Raum befinden sich zwei quaderförmige turmartige Wärmetauscherschränke, die an mindestens zwei vertikalen Seitenflächen Wärmetauscher aufweisen. Der Schrank ist auf einem Öffnungen aufweisenden Doppelboden angeordnet, dem aus dem Wärmetauscherschrank austretende gekühlte Luft dem Raum zugeführt wird. Unterhalb des Schranks im Doppelboden kann ein Radiallüfter angeordnet sein, um die gekühlte Luft zu fördern. Alternativ besteht die Möglichkeit, den Radiallüfter oberhalb des Schrankes oder innerhalb von diesem nahe dessen Oberseite anzuordnen.

Der JP 2011-220 665 A ist ein Luftkonditionierungssystem zu entnehmen. Dabei wird über den Deckenbereich Warmluft abgesaugt, die sodann den Wärmetauscher durchsetzt, die Abschnitte einer Begrenzungswandung des Raums bilden.

Die EP 2 568 793 A2 bezieht sich auf ein Verfahren und eine Anordnung zum Klimatisieren eines Raumes. Dabei sind unterhalb von Warmgängen in einem Hohlraum Ventilatoren angeordnet, über die Warmluft angesaugt wird, die entweder Wärmetauschern zugeführt oder als Fortluft abgeführt wird.

Aus der JP 2009-293 851 A ist eine Kühlanordnung zum Kühlen eines Raumes bekannt, bei der zwischen Racks Wärmetauscher angeordnet sind, um entstehende Warmluft zu kühlen.

Bei einer Kühlanordnung nach der DE 10 2011 117 988 B1 werden quaderförmige turmartige Wärmetauscherschränke benutzt, die an mindestens zwei vertikalen Seitenflächen Wärmetauscher aufweisen.

Um Luft zu konditionieren, sieht die JP 2011- 085 267 A gleichfalls zwischen Racks angeordnete Gehäuse mit Wärmetauschern vor.

Nach der US 8 031 468 B2 ist oberhalb eines Warmgangs ein Gehäuse mit Kühleinrichtungen vorgesehen.

Der EP 2 501 214 A2 ist eine Anordnung zum Klimatisieren von Kaltgängen zu entnehmen, die in einem Warmraum angeordnet sind. Dieser ist mittels einer Wandung von einem zweiten Raum getrennt, wobei die Wandung bereichsweise als durch einen oder mehrere Wärmetauscher gebildete Kühlwand ausgebildet ist. Die durch den Wärmetauscher strömende Luft wird einem Hohlboden zugeführt, in dem sich Ventilatoren befinden, über die die gekühlte Luft den Kaltgängen zugeführt wird.

Ein Kühlkreislauf zur Verwendung in einem Rechenzentrum ist aus der WO 2013/056787 A1 bekannt. In Racks angeordnete wärmeerzeugende Geräte sind auf einem Hohlboden angeordnet. Die Racks begrenzen einen Kaltgang, dem gekühlte Luft über den Hohlboden zugeführt wird. Hierzu benötigte Ventilatoren sind entweder innerhalb des Hohlbodens oder im Kaltgang angeordnet. Abschnitte des Hohlbodens können als Wärmetauscherflächen ausgebildet sein.

Die eine effiziente Kühlung insbesondere von Rechnerräumen ermöglichenden Anordnungen weisen nach dem Stand der Technik grundsätzlich einen Hohlboden auf, um über Öffnungen in diesem entweder Kühlluft dem Raum zuzuführen oder aus diesem Warmluft abzusaugen. Die Kaltgänge selbst verlaufen beabstandet zu den Raumbegrenzungen. Als Ventilatoren werden grundsätzlich Radialventilatoren verwendet.

Der vorliegenden Erfindung liegt die Aufgabe zugrunde, ein Verfahren und eine Anordnung der eingangs genannten Art so weiterzubilden, dass mit hoher Energieeffizienz eine Kühlung von Kaltgängen erfolgen kann, wobei die durch die zum Einsatz gelangenden Ventilatoren bedingten Druckverluste gering gehalten werden sollen. Auch sollen sich gute Strömungsverhältnisse ergeben.

Zur Lösung der Aufgabe wird verfahrensmäßig im Wesentlichen vorgeschlagen, dass in der Begrenzungswandung zumindest eine Öffnung vorhanden ist, der der zumindest eine Ventilator zugeordnet oder in der dieser angeordnet wird, und dass der zumindest eine Kaltgang mit der Begrenzungswandung derart verbunden wird, dass die Öffnung von dem eingehausten Kaltgang oder eine Verbindung mit diesem umgeben wird.

Abweichend vom gattungsbildenden Stand der Technik geht der zumindest eine Kaltgang, vorzugsweise gehen mehrere Kaltgänge unmittelbar von der nachstehend auch vereinfacht als Wandung bezeichnete Begrenzungswandung des Warmraums aus, die bereichsweise als Kühlwand ausgebildet ist, wobei die Warmluft durch die durch Wärmetauscher gebildete Kühlwand in den von der Wandung abgetrennten zweiten Raum strömt, um sodann über den zumindest einen Ventilator, der dem zumindest einen Kaltgang zugeordnet ist, angesaugt zu werden, wobei die Druckseite des Ventilators kaltgangsseitig verläuft. Hierzu ist insbesondere vorgesehen, dass der Ventilator in der in der Wandung vorhandenen Öffnung integriert ist, so dass die Druckseite des insbesondere als Axialventilator ausgebildeten Ventilators unmittelbar an den Kaltgang angrenzt.

Geht von dem Kaltgang eine Verlängerung oder eine sonstige Verbindung mit diesem aus, die die Öffnung mit dem Ventilator umgibt, so ist dies gleichfalls eine unmittelbare Verbindung des Kaltgang mit der Begrenzungswandung.

Durch die erfindungsgemäße Lehre bedarf es keines Hohlbodens. Ferner können Axialventilatoren mit großen Ventilatorlaufrädern zum Einsatz gelangen, so dass demzufolge eine hohe Energieeffizienz gegeben ist.

Die die Kühlwand bildenden Wärmetauscher sind in den Bereichen der Wandung ausgebildet, die nicht von den Kaltgängen, die von den in Reihen angeordneten wärmeerzeugenden Geräten begrenzt sind, abgedeckt sind. Mit anderen Worten kann über die gesamte Wärmetauscherfläche Warmluft angesaugt werden.

Die Kaltgänge selbst sind derart eingehaust, dass die in die Kaltgänge strömende gekühlte Luft grundsätzlich ausschließlich durch die wärmeerzeugenden Geräte bzw. den diese aufnehmenden Racks oder Gestelle hindurchströmt, um sodann aus dem die Kaltgänge umgebenden Warmraum über die Wärmetauscher abgesaugt zu werden.

Die Kaltgänge sind eingehaust, d. h., dass Kopf und die der Begrenzungswandung des Warmraums gegenüberliegende Stirnwandung geschlossen sind, so dass erwähntermaßen die dem Kaltgang zugeführte gekühlte Luft durch die Racks hindurchströmen muss. Die Stirnwandung kann selbstverständlich auch durch ein oder mehrere Racks gebildet werden.

Unabhängig hiervon bleiben die nach dem Stand der Technik bekannten Vorteile erhalten, da eine problemlose Wartung des oder der Wärmetauscher sowie des oder der Ventilatoren erfolgen kann, da diese von dem zweiten Raum, der als Wartungsgang zu bezeichnen ist, problemlos gewartet werden können. Sofern die warmraumseitig verlaufende Kühlfläche einen Filter aufweist, muss dieser selbstverständlich von der Warmraumseite gewartet werden.

Die Erfindung zeichnet sich folglich dadurch aus, dass in der Begrenzungswandung zumindest eine Öffnung ausgebildet wird, der der zumindest eine Ventilator zugeordnet oder in der dieser angeordnet wird, und dass der zumindest eine Kaltgang mit der Wandung derart verbunden wird, dass die Öffnung von dem eingehausten Kaltgang bzw. Verlängerung oder Verbindung von diesem umgeben wird, wobei insbesondere vorgesehen ist, dass in dem Warmraum mehrere Kaltgänge angeordnet werden, wobei jeder Kaltgang zumindest eine in der Wandung vorhandene Öffnung mit zumindest einem Ventilator umgibt bzw. dieser zugeordnet ist.

Des Weiteren ist vorgesehen, dass zwischen Kaltgängen und außerhalb von den die Kaltgänge begrenzenden Reihen, die die wärmeerzeugenden Geräte enthalten, verlaufende Bereiche der Begrenzungswandung zumindest bereichsweise als Wärmetauscherfläche, also als Kühlwand, ausgebildet werden.

Bevorzugterweise ist vorgesehen, dass der Ventilator in der Wand zumindest abschnittsweise eingelassen, also in dieser integriert wird.

Die Erfindung wird insbesondere auch dann nicht verlassen, wenn dem Warmraum durch zwei Begrenzungswandungen getrennte zwei zweite Räume zugeordnet sind, wobei in jeder Wandung zumindest eine Öffnung mit zumindest einem dieser zugeordneten Ventilator vorhanden ist, wobei ein Kaltgang derart innerhalb des Warmraums angeordnet ist, dass jede der zumindest einen Öffnungen mit dem Kaltgang, insbesondere mit dessen Stirnseiten verbunden ist, also von gegenüberliegenden Seiten Kaltluft eingetragen wird. Die Wandungen selbst sind entsprechend zuvor erläuterter Merkmale ausgebildet.

Unabhängig hiervon ist insbesondere vorgesehen, dass die kalte Luft dem Kaltgang mit einer Strömungsgeschwindigkeit zugeführt wird, dass im Bereich des der Öffnung nächstliegenden wärmeerzeugenden Geräts bzw. des dieses aufnehmenden Gestells ein dynamischer Druck p mit p ≤ 10 Pa herrscht.

Um sicherzustellen, dass im Bereich des der jeweiligen Öffnung nächstliegenden wärmeerzeugenden Geräts bzw. des dieses aufnehmenden Gestells die Kaltluft eine Geschwindigkeit v aufweist, die gewährleistet, dass diese durch das Gestell hindurchströmt, sollte v ≤ 5 m/s, vorzugsweise v ≤ 4 m/s betragen. Hierzu besteht nach einer Weiterbildung der Erfindung die Möglichkeit, den Querschnitt des Kaltgangs entsprechend zu verändern. So kann der Kaltgang z. B. mit kopfseitig verlaufenden Hauben versehen sein, durch die eine entsprechende Querschnittserweiterung bewirkt wird. Querschnitt ist dabei die Fläche, die parallel zu der die Öffnung aufweisende Begrenzungswandung verläuft.

Eine Anordnung der eingangs genannten Art zeichnet sich insbesondere dadurch aus, dass der Ventilator in einer Öffnung der Begrenzungswandung angeordnet oder mit dieser strömungstechnisch verbunden ist und dass zumindest ein Bereich einer Seite, insbesondere eine Stirnseite, des zumindest einen Kaltgangs von einem Abschnitt der Begrenzungswandung begrenzt ist, innerhalb dessen die Öffnung verläuft.

Abweichend von vorbekannten Lösungen geht der Kaltgang unmittelbar von der den Warmraum begrenzenden und bereichsweise als Kühlwand ausgebildeten Wandung aus, wobei die den Kaltgang begrenzenden Racks nicht unmittelbar an der Wandung angrenzen müssen, vielmehr der Kaltgang durch geschlossene Begrenzungen verlängert sein kann, über die der entsprechende Bereich umfangsseitig geschlossen ist, so dass weiterhin gekühlte Luft ausschließlich über die Racks in den Warmraum strömen kann.

Verlängerung schließt auch sonstige Verbindungen zwischen dem Kaltgang und der Begrenzungswandung ein, um die Öffnung mit dem zugeordneten Ventilator zu umgeben.

Des Weiteren sieht die Erfindung vor, dass zwischen Längsseiten von benachbarten Kaltgängen verlaufende Bereiche der Wandung zumindest bereichsweise als Kühlwand durch Integration eines oder mehrerer Wärmetauscher ausgebildet sind.

Um eine gewünschte Kühlleistung zu erreichen, ist insbesondere vorgesehen, dass innerhalb der von dem Abschnitt der Wandung verschlossenen Stirnseite des Kaltgangs mehrere Öffnungen bzw. Ventilatoren vorhanden sind. Hierdurch besteht auch die Möglichkeit eines redundanten Aufbaus.

Als Ventilator wird insbesondere ein Axialventilator benutzt. Die Erfindung würde jedoch nicht verlassen werden, wenn eine andere Art eines Ventilators zum Einsatz gelangt.

Unabhängig hiervon besteht auch die Möglichkeit, dass der Warmraum über zwei Begrenzungswandungen, vorzugsweise gegenüberliegende Wandungen, von zwei zweiten Räumen abgetrennt ist, dass in jeder der von dem Boden, von dem die Kaltgänge ausgehen, sich erstreckenden und insbesondere senkrecht zu diesem verlaufenden Wandungen zumindest eine Öffnung mit zumindest einem dieser zugeordneten Ventilator vorhanden ist und dass jede der Öffnungen mit dem zumindest einen Kaltgang verbunden ist, insbesondere jede Stirnseite des Kaltganges jeweils eine der Öffnungen der Wandungen umgibt.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung der Zeichnung zu entnehmenden bevorzugten Ausführungsbeispielen.

Es zeigen:
- Fig. 1: eine Draufsicht auf eine Anordnung zum Konditionieren von Kaltgängen und
- Fig. 2: die Anordnung gemäß Fig. 1 in perspektivischer Darstellung, teilweise weggebrochen.

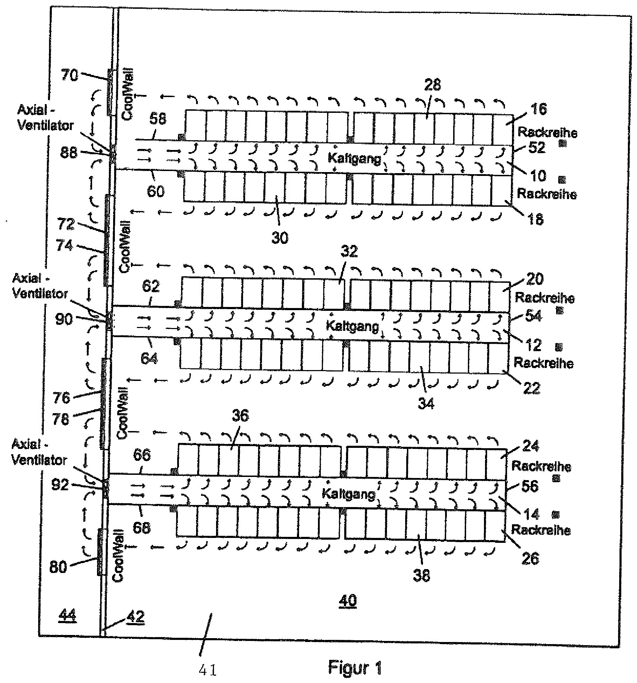

In den Figuren sind rein prinzipiell Kaltgänge 10, 12, 14 dargestellt, die von Reihen 16, 18 bzw. 20, 22 bzw. 24, 26 von Racks begrenzt sind, von denen einige mit den Bezugszeichen 28, 30, 32, 34, 36, 38 rein beispielhaft gekennzeichnet sind. In den Racks 28, 30, 32, 34, 36, 38 befinden sich wärmeerzeugende Geräte, die zu kühlen sind. Hierzu wird den Kaltgängen 10, 12, 14 konditionierte, d. h., gekühlte Luft zugeführt, die ausschließlich durch die Racks bzw. die in diesen angeordnete wärmeerzeugende Geräte wie Server oder sonstige Rechner geführt wird, wie die Pfeile in der Fig. 1 symbolisieren sollen.

Die Kaltgänge 10, 12. 14, die in ihren Längsseiten von den Reihen 16, 18 bzw. 20, 22 bzw. 24, 26 begrenzt werden, befinden sich in einem als Warmraum 40 zu bezeichnenden ersten Raum, der über zumindest eine von dem Boden 41 des Warmraums 40 ausgehende und insbesondere vertikal bzw. senkrecht zu dem Boden 41 verlaufende Begrenzungswandung 42 von einem zweiten Raum 44 abgegrenzt ist, der auch als Wartungsraum oder -gang bezeichnet werden kann.

Die Kaltgänge 10, 12, 14, die von dem Boden 41 des Warmraums 40 ausgehen, sind eingehaust, d. h., die in den Kaltgängen 10, 12, 14 strömende gekühlte Luft kann erwähntermaßen ausschließlich über die Racks 28, 30, 32, 34, 36, 38 in den Warmraum 40 strömen. Hierzu ist der Bereich zwischen den Reihen 16, 18 bzw. 20, 22 bzw. 24, 26 gegenüber dem Warmraum 40 geschlossen. Kopfseitig verläuft hierzu zwischen den Reihen 16, 18 bzw. 20, 22 bzw. 24, 26, also die Kaltgänge 10, 12, 14 oberseitig abdeckend bzw. verschließend jeweils eine haubenförmige im Schnitt U-förmige Verkleidung 46, 48, 50, die jeweils - wie die Kaltgänge 10, 12, 14 - auf der in Bezug auf die Begrenzungswandung 42 fernliegenden bzw. abgewandten Stirnseite geschlossen sind. In der Draufsicht der Fig. 1 sind die entsprechenden geschlossenen Stirnseiten mit den Bezugszeichen 52, 54, 56 gekennzeichnet.

Wie die Darstellung der Fig. 1 verdeutlicht, erstrecken sich die Reihen 16, 18, 20, 22, 24, 26 nicht bis zur Begrenzungswandung 42, gleichwenn dies möglich wäre. Im Ausführungsbeispiel sind die Kaltgänge 10, 12, 14 über die Reihen 16, 18, 20, 22, 24, 26 hinaus in Richtung der Begrenzungswandung 42 durch Verkleidungen 58, 60, 62, 64, 66, 68 wie Stellwände verlängert und schließen im Wesentlichen dicht gegenüber der Wandung 42 ab, so dass die gewünschte Kaltluftzuführung in den Kaltgang 10, 12, 14 sichergestellt ist. Die durch die Stellwände 58, 60, 62, 64, 66, 68, begrenzten Bereiche sind somit Abschnitte der Kaltgänge 10, 12, 14, wobei die einen Kaltgang 10, 12, 14 verlängernden Stellwände 58, 60 bzw. 62, 64 bzw. 66, 68 kopfseitig durch jeweils eine der Hauben 46, 48, 50 verschlossen sind. Insoweit sind die Fig. gleichfalls selbsterklärend.

Wie sich aus der Zeichnung ergibt, sind in der Begrenzungswandung 42 Öffnungen 82, 84, 86 vorhanden, die von den wandseitig verlaufenden Stirnrändern der Kaltgänge 10, 12, 14 bzw. der Stellwände 58,60, 62, 64, 66, 68 bzw. der Hauben 46, 48, 50 umgeben sind, wie insbesondere die Fig. 1 unmissverständlich verdeutlicht.

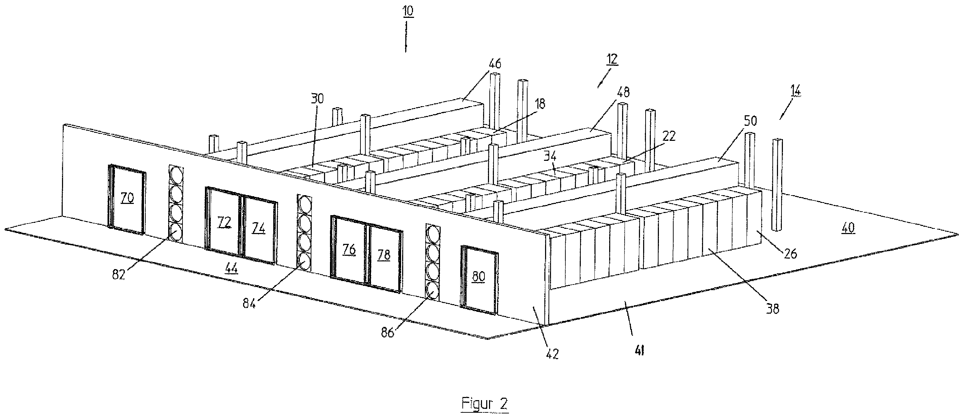

In den Öffnungen 82, 84, 86 sind Ventilatoren angeordnet, die in der Fig. 1 mit den Bezugszeichen 88, 90, 92 gekennzeichnet sind. Dabei können - wie die Fig. 2 erkennbar macht - in der jeweiligen Öffnung 82, 84, 86 mehrere Ventilatoren übereinander angeordnet sein. Hierzu können die Ventilatoren von einer Halterung ausgehen, die in der Öffnung 82, 84, 86 angeordnet oder mit dieser verbunden ist. Auch können mehrere Öffnungen übereinander angeordnet sein, wobei jeder Öffnung ein Ventilator zugeordnet ist.

Befindet sich der jeweilige Ventilator 88, 90, 92 vorzugsweise in der Öffnung 82, 84, 86 bzw. durchsetzt diese zumindest bereichsweise, so kann auch eine andere Verbindung zu der jeweiligen Öffnung 82, 84, 86 erfolgen. Wesentlich ist, dass über den jeweiligen Ventilator 88, 90, 92 gekühlte Luft dem jeweiligen zugeordneten Kaltgang 10, 12, 14 zugeführt wird.

Erfindungsgemäß ist folglich die Druckseite des jeweiligen Ventilators 88, 90, 92 mit dem zugeordneten Kaltgang 10, 12, 14 verbunden. Die Saugseite des jeweiligen Ventilators 88, 90, 92 ist mit dem zweiten Raum 44 verbunden bzw. verläuft in diesem, um somit aus dem Warmraum 70 über die Wärmetauscher 70, 72, 74, 76, 78, 80 Warmluft anzusaugen, damit diese über die Wärmetauscher 70, 72, 74, 76, 78, 80 gekühlt wird und sodann den Kaltgängen 10, 12, 14 als Kühlluft zugeführt werden kann.

Durch die kaltkanalstirnseitige Anordnung der Ventilatoren 88, 90, 92 besteht die Möglichkeit, Axialventilatoren einzusetzen, die druckseitig mit den Kaltgängen 10, 12, 14 verbunden sind. Saugseitig gehen die Ventilatoren 88, 90, 92 von dem als Wartungsgang zu bezeichnenden zweiten Raum 44 aus.

Es kann mit geringen Druckverlusten unter Einsatz großer Ventilatorlaufräder eine Verwendung von Axialventilatoren mit hoher Energieeffizienz unter Einsatz großflächiger Wärmetauscher gekühlte Luft den Kaltgängen 10, 12, 14 zugeführt werden. Optimale Strömungsverhältnisse ergeben sich.

Eine hohe Nutzkühlleistung bei geringer Aufstellfläche ist gegeben, insbesondere aufgrund der Tatsache, dass hinreichend Platz für die Ventilatoren gegeben ist, ein hervorzuhebender Vorteil gegenüber den Anordnungen, bei denen der Ventilator in einem Hohl- oder Doppelboden angeordnet ist, wie dies grundsätzlich der Stand der Technik vorsieht. Durch die Anordnung der Ventilatoren in der Wand bzw. die Befestigung für die Ventilatoren an dieser sind im Vergleich zu den Anordnungen, bei denen die Ventilatoren vom Bodenbereich des Warmgangs ausgehen und strömungstechnisch mit einem Hohlboden verbunden sind, geringere Breiten des Wartungsgangs, also des zweiten Raums 44 erforderlich.

Es ergibt sich ein Systemaufbau mit abgestimmten Einzelelementen, wobei ein problemloses Einbringen der einzelnen Module ermöglicht wird. Eine Wartungsfreundlichkeit ist dadurch gegeben, dass die für die Kühlung erforderlichen Komponenten, d. h. die Ventilatoren 88, 90, 92 und die Wärmetauscher 70, 72, 74, 76, 78, 80 von dem Wartungsgang, also dem zweiten Raum 44 zugänglich sind.

Sonderkonstruktionen sind nicht erforderlich, vielmehr kann auf eine verfügbare und bewährte Standardtechnologie zurückgegriffen werden.

Ist in der zeichnerischen Darstellung der jeweilige Kaltgang 10, 12, 14 stirnseitig mit der Begrenzungswandung 42 und die Öffnung 82, 84, 86 umgebend dargestellt, so besteht selbstverständlich auch die Möglichkeit, dass der Kaltgang über eine eine Längsseite durchsetzende Verbindung an der Wandung 42 und die Öffnung 82, 84, 86 umgebend angeschlossen ist.

Ferner ist es nicht erforderlich, dass die Kaltgänge kopfseitig durch Hauben verschlossen sind. Vielmehr kann unmittelbar auf den Racks eine Abdeckung vorgesehen sein, so dass die Höhe der Kaltgänge denen der Racks entspricht.

Durch die haubenförmigen Verkleidungen 46, 48, 50 ergibt sich eine Querschnittsvergrößerung des Kaltgangs 10, 12, 14, um sicherzustellen, dass in dem der jeweiligen Öffnung am nächsten liegenden Rack, also den in diesen angeordneten wärmeerzeugenden Geräten die Strömungsgeschwindigkeit der zugeführten Kaltluft ≤ 5 m/s, insbesondere ≤ 4 m/s, beträgt. Hierdurch ist sichergestellt, dass Kaltluft durch das Rack hindurchdringt und nicht durch dieses angesaugt wird.

Des Weiteren ist darauf hinzuweisen, dass nach einer Weiterbildung und abweichend von den zeichnerischen Darstellungen jeder Kaltgang über seine jeweiligen Stirnseite mit Kaltluft beaufschlagt werden kann. Dies bedeutet, dass der Warmraum über zwei Begrenzungswandungen von zwei zweiten Räumen begrenzt ist, wobei jeder Kaltgang mit jeder Stirnseite mit der dieser zugewandten Wand verbunden ist und eine Öffnung umgibt, die zumindest einen Ventilator aufweist bzw. der zumindest ein Ventilator zugeordnet ist. Zeichnerisch würde sich dies derart gestalten, dass entsprechend der in der Fig. 1 links dargestellten Begrenzungswandung 42 rechts eine entsprechende Begrenzungswandung verlaufen würde, von der über Öffnungen konditionierte Luft in den jeweiligen Kaltgang 10 12, 14 strömt.

Die Begrenzungswand 42 muss selbstverständlich nicht geradlinig verlaufen, kann vielmehr aus mehreren Abschnitten bestehen, die nicht zwingend fluchtend zueinander ausgerichtet sein müssen.

## Patentansprüche

1. Verfahren zum Klimatisieren zumindest eines zumindest bereichsweise von wärmeerzeugenden Geräten begrenzten in einem Warmraum (40) angeordneten Kaltgangs (10, 12, 14), wobei der Warmraum mittels zumindest einer Begrenzungswandung (42) von zumindest einem zweiten Raum (44) getrennt ist und zumindest ein Bereich der zumindest einen Begrenzungswandung durch zumindest einen Wärmetauscher (70, 72, 74, 76, 78, 80) bereichsweise als Kühlwand ausgebildet ist, und wobei über zumindest einen Ventilator (88, 90, 92) über den zumindest einen Wärmetauscher geförderte Luft dem zumindest einen Kaltgang zugeführt wird,
**dadurch gekennzeichnet,**
**dass** in der zumindest einen Begrenzungswandung (42) zumindest eine Öffnung (82, 84, 86) vorhanden ist, der der zumindest eine aus dem Warmraum (40) Warmluft durch die durch den zumindest einen Wärmetauscher gebildete Kühlwand ansaugende Ventilator (88, 90, 92) zugeordnet oder in der dieser angeordnet wird, und dass der zumindest eine Kaltgang (10, 12, 14) mit der zumindest einen Begrenzungswandung derart verbunden wird, dass die Öffnung von dem Kaltgang umgeben wird.

2. Verfahren nach Anspruch 1,
**dadurch gekennzeichnet,**
**dass** in dem Warmraum (40) mehrere Kaltgänge (10, 12, 14) angeordnet werden, wobei jeder Kaltgang zumindest eine in der zumindest einen Begrenzungswandung vorhandene Öffnung (82, 84, 86) mit dem zumindest einen zugeordneten oder in dieser angeordneten Ventilator (88, 90, 92) umgibt.

3. Verfahren nach Anspruch 1 oder 2,
**dadurch gekennzeichnet,**
**dass** zwischen benachbarten Kaltgängen (10, 12, 14) und außerhalb von diesen verlaufende Bereiche der zumindest einen Begrenzungswandung (42) zumindest bereichsweise als Wärmetauscherflächen ausgebildet werden.

4. Verfahren nach zumindest einem der vorherigen Ansprüche,
**dadurch gekennzeichnet,**
**dass** als Ventilator (80, 90, 92) ein Axialventilator verwendet wird.

5. Verfahren nach zumindest einem der vorherigen Ansprüche,
**dadurch gekennzeichnet,**
**dass** der Ventilator (80, 90, 92) in der zumindest einen Begrenzungswandung (42) zumindest abschnittsweise eingelassen wird.

6. Verfahren nach zumindest einem der vorherigen Ansprüche,
**dadurch gekennzeichnet,**
**dass** der Warmraum (40) über zumindest zwei Begrenzungswandungen (42) gegenüber zwei zweiten Räumen (44) abgetrennt wird und dass in jeder Begrenzungswandung zumindest eine Öffnung (82, 84, 86) mit jeweils zumindest einem Ventilator vorgesehen wird und der zumindest eine Kaltgang (10, 12, 14) jede der Öffnungen umgibt.

7. Verfahren nach zumindest einem der vorherigen Ansprüche,
**dadurch gekennzeichnet,**
**dass** die kalte Luft dem Kaltgang (10, 12, 14) mit einer Strömungsgeschwindigkeit zugeführt wird, dass im Bereich des der Öffnung (82, 84, 86) nächstliegenden wärmeerzeugenden Gerätes bzw. des dieses aufnehmenden Gestells ein dynamischer Druck p mit p ≤ 10 Pa herrscht.

8. Verfahren nach zumindest einem der vorherigen Ansprüche,
**dadurch gekennzeichnet,**
**dass** der Querschnitt des Kaltgangs (10, 12, 14) derart ausgelegt wird, dass die Strömungsgeschwindigkeit v der dem Kaltgang zugeführten Kaltluft im Bereich des der Öffnung (82, 84, 86) nächstliegenden wärmeerzeugenden Gerätes bzw, des dieses aufnehmenden Gestells beträgt v ≤ 5 m/s, insbesondere v ≤ 4 mm/s.

9. Anordnung zum Klimatisieren von zumindest einem in einem Warmraum (40) angeordneten eingehausten Kaltgang (10, 12, 14), der strömungstechnisch über zumindest einen Ventilator (88, 90, 92) mit einem durch eine bereichsweise als Kühlwand ausgebildete Begrenzungswandung (42) von dem Warmraum begrenzten zweiten Raum (44) verbunden ist, wobei der Ventilator strömungstechnisch druckseitig mit dem zumindest einen Kaltgang und saugseitig über zumindest einen einen Abschnitt der Begrenzungswandung bildenden Wärmetauscher (70, 72, 74, 76, 80) mit dem Warmraum verbunden ist,
**dadurch gekennzeichnet,**
**dass** der Ventilator (88, 90, 92) in einer Öffnung (82, 84, 86) der Begrenzungswandung (42) angeordnet oder mit dieser verbunden ist, und dass zumindest ein Bereich einer Seite des zumindest einen Kaltgangs (10, 12, 14) oder eine Verbindung mit diesem von einem Abschnitt der Begrenzungswandung begrenzt ist, innerhalb dessen die Öffnung verläuft.

10. Anordnung nach Anspruch 9,
**dadurch gekennzeichnet,**
**dass** eine der Stirnseiten des Kaltgangs (10, 12, 14) von dem Abschnitt der Begrenzungswandung (42) mit der in dem Kaltgang mündenden Öffnung (82, 84, 86) begrenzt ist.

11. Anordnung nach Anspruch 9 oder 10,
**dadurch gekennzeichnet,**
**dass** zwischen Längsseiten von benachbarten Kaltgängen (10, 12, 14) verlaufende Bereiche der Begrenzungswandung (42) zumindest bereichsweise durch einen oder mehrere Wärmetauscher (70, 72, 74, 76, 78, 80) gebildet sind.

12. Anordnung nach zumindest einem der Ansprüche 9 bis 11,
**dadurch gekennzeichnet,**
**dass** innerhalb des von dem Kaltgang (10, 12, 14) oder einem von diesem ausgehenden Abschnitt abgedeckten Bereichs der Begrenzungswandung (42) mehrere Öffnungen (82, 84, 86) bzw. Ventilatoren (88, 90, 92) vorgesehen sind.

13. Anordnung nach zumindest einem der Ansprüche 9 bis 12,
**dadurch gekennzeichnet,**
**dass** die mehreren Öffnungen (82, 84, 86) in einer vertikal verlaufenden Reihe angeordnet sind.

14. Anordnung nach zumindest einem der Ansprüche 9 bis 13,
**dadurch gekennzeichnet,**
**dass** der Warmraum (40) über zwei Begrenzungswandungen (42), vorzugsweise gegenüberliegenden Begrenzungswandungen (42), von zwei zweiten Räumen (44)abgetrennt ist, dass in jeder der Begrenzungswandungen zumindest eine Öffnung (82, 84, 86) mit zumindest einem dieser zugeordneten Ventilator vorhanden ist und dass jede der Öffnungen mit dem zumindest einen Kaltgang (10, 12, 14) verbunden ist, insbesondere jede Stirnseite des Kaltganges jeweils eine der Öffnungen der zwei Begrenzungswandungen umgibt.

## Claims

1. A method for air-conditioning at least one cold aisle (10, 12, 14) which at least partially bounded by heat-generating devices and is arranged in a hot room (40), wherein the hot room is separated from at least one second room (44) by means of at least one boundary wall (42), and at least one region of the at least one boundary wall is formed in part as a cooling wall by means of at least one heat exchanger (70, 72, 74, 76, 78, 80), and wherein air that is conveyed through the at least one heat exchanger by means of at least one fan (88, 90, 92) is supplied to the at least one cold aisle,
**characterized in that**
in the at least one boundary wall (42) at least one opening (82, 84, 86) is provided, to which at least one fan (88, 90, 92), which sucks warm air from the hot room (40) through the cooling wall, formed by means of the at least one heat exchanger, is assigned or in which at least one fan is disposed, and **in that** the at least one cold aisle (10, 12, 14) is connected to the at least one boundary will in such a way that the opening is surrounded by the cold aisle.

2. The method of claim 1,
**characterized in that**
a plurality of cold aisles (10, 12, 14) are arranged in the hot room (40), wherein each cold aisle surrounds at least one opening (82, 84, 86) provided in the at least one boundary wall, along with the at least one fan (88, 90, 92) assigned or disposed therein.

3. The method according to claim 1 or 2,
**characterized in that**
between adjacent cold aisles (10, 12, 14), regions of the at least one boundary wall (42) that extend outside of the cold aisles are embodied at least partially as heat exchange surfaces.

4. The method according to at least one of the preceding claims,
**characterized in that**
an axial fan is used as the fan (80, 90, 92).

5. The method according to at least one of the preceding claims,
**characterized in that**
the fan (80, 90, 92) is at least partially recessed into the at least one boundary wall (42).

6. The method according to at least one of the preceding claims,
**characterized in that**
the hot room (40) is separated from two second rooms (44) by at least two boundary walls (42), and **in that** at least one opening (82, 84, 86) with at least one fan per opening is provided in each boundary wall, with the at least one cold aisle (10, 12, 15) surrounding each of the openings.

7. The method according to at least one of the preceding claims,
**characterized in that**
the cold air is supplied to the cold aisle (10, 12, 14) at a flow velocity that will ensure a dynamic pressure p of p ≤ 10 Pa in the region of the heat-generating device that is closest to the opening (82, 84, 86), or in the region of the frame that holds said device.

8. The method according to at least one of the preceding claims,
**characterized in that**
the cross-section of the cold aisle (10, 12, 14) is configured such that the flow velocity v of the cold air being supplied to the cold aisle is v ≤ 5m/s, in particular v ≤ 4 mm/s in the region of the heat-generating device that is closest to the opening (82, 84, 86) or in the region of the frame that holds said device.

9. An arrangement for air-conditioning at least one enclosed cold aisle (10, 12, 14), which is arranged in a hot room (40) and is fluidically connected via at least one fan (88, 90, 92) to a second room (44) that is separated from the hot room by a boundary wall (42) embodied partially as a cooling wall, wherein the fan is fluidically connected on the exhaust side to the at least one cold aisle and on the intake side to the hot room, via at least one heat exchanger (70, 72, 74, 76, 80), which forms a portion of the boundary wall,
**characterized in that**
the fan (88, 90, 92) is arranged in an opening (82, 84, 86) in the boundary wall (42) or is connected to said opening, and **in that** at least one region of one end of the at least one cold aisle (10, 12, 14) or a connection to said cold aisle, is delimited by a portion of the boundary wall within which the opening extends.

10. The arrangement according to claim 9,
**characterized in that**
one of the end faces of the cold aisle (10, 12, 14) is delimited by the portion of the boundary wall (42) that contains the opening (82, 84, 86) that leads into the cold aisle.

11. The arrangement according to claim 9 or 10,
**characterized in that**
regions of the boundary wall (42) that extend between longitudinal sides of adjacent cold aisles (10, 12, 14) are at least partially formed by one or more heat exchangers (70, 72, 74, 76, 78, 80).

12. The arrangement according to claim 9 to 11,
**characterized in that**
within the region of the boundary wall (42) that is covered by the cold aisle (10, 12, 14) or by a portion that extends outward from the cold aisle, a plurality of openings (82, 84, 86) and/or fans (88, 90, 92) are provided.

13. The arrangement according to claim 9 to 12,
**characterized in that**
the plurality of openings (82, 84, 86) are arranged in a vertically extending row.

14. The arrangement according to claim 9 to 13,
**characterized in that**
the hot room (40) is separated from two second rooms (44) by two boundary walls (42), preferably two opposite boundary walls (42), **in that** at least one opening (82, 84, 86) with at least one fan assigned thereto is provided in each of the boundary walls, and **in that** each of the openings is connected to the at least one cold aisle (10, 12, 14), in particular each end face of each cold aisle surrounds one of the openings in the two boundary walls.

## Revendications

1. Procédé de climatisation d'au moins une allée froide (10, 12, 14) agencée dans une chambre chaude (40) et délimitée au moins par endroit par des appareils générant de la chaleur, la chambre chaude étant séparée d'au moins une seconde chambre (44) à l'aide d'au moins une paroi de délimitation (42) et au moins une zone d'au moins une paroi de délimitation étant par endroit une paroi de refroidissement formée par au moins un échangeur de chaleur (70, 72, 74, 76, 78, 80) et l'air refoulé par au moins un échangeur de chaleur par l'intermédiaire d'au moins un ventilateur (88, 90, 92) étant amené à au moins une allée froide,
**caractérisé en ce**
**qu'**il y a au moins une ouverture (82, 84, 86) dans au moins une paroi de délimitation (42), à laquelle est associé au moins un ventilateur (88, 90, 92) aspirant l'air chaud provenant de la chambre chaude (40) à travers la paroi de refroidissement formée par au moins un échangeur de chaleur ou dans laquelle ce dernier est disposé, et qu'au moins une allée froide (10, 12, 14) est raccordée à au moins une paroi de délimitation de sorte que l'ouverture est entourée par l'allée froide.

2. Procédé selon la revendication 1,
**caractérisé en ce**
**qu'**il y a plusieurs allées froides (10, 12, 14) disposées dans la chambre chaude (40), chaque allée froide entourant au moins une ouverture (82, 84, 86) présente dans au moins une paroi de délimitation avec au moins un ventilateur (88, 90, 92) associé ou disposé dans cette dernière.

3. Procédé selon la revendication 1 ou 2,
**caractérisé en ce**
**que** des zones d'au moins une paroi de délimitation (42) s'étendant entre des allées froides adjacentes (10, 12. 14) et en-dehors de ces dernières sont conçues au moins par endroit sous forme de surfaces d'échange de chaleur.

4. Procédé selon l'une des revendications précédentes,
**caractérisé en ce**
**qu'**un ventilateur axial est utilisé comme ventilateur (80, 90. 92).

5. Procédé selon l'une des revendications précédentes,
**caractérisé en ce**
**que** le ventilateur (80, 90, 92) est encastré au moins par endroit dans au moins une paroi de délimitation (42).

6. Procédé selon l'une des revendications précédentes,
**caractérisé en ce**
**que** la chambre chaude (40) est séparée de deux secondes chambres (44) par au moins deux parois de délimitation (42) et qu'au moins une ouverture (82, 84, 86) est prévue dans chaque paroi de délimitation avec au moins chaque fois un ventilateur et qu'au moins une allée froide (10, 12, 14) entoure chacune des ouvertures.

7. Procédé selon l'une des revendications précédentes,
**caractérisé en ce**
**que** l'air froid est amené à l'allée froide (10, 12, 14) à une vitesse d'écoulement, que dans la zone de l'appareil générateur de chaleur le plus proche de l'ouverture (82, 84, 86) ou du rayonnage logeant ce dernier il règne une pression dynamique p, pour p ≤ 10 Pa.

8. Procédé selon l'une des revendications précédentes,
**caractérisé en ce**
**que** la section transversale de l'allée froide (10, 12, 14) est conçue de telle sorte que la vitesse d'écoulement v de l'air froid amené à l'allée froide dans la zone de l'appareil générateur de chaleur le plus proche de l'ouverture (82, 84, 86) ou du rayonnage logeant ce dernier est v ≤ 5 m/s, en particulier v ≤ 4 mm/s.

9. Dispositif de climatisation d'au moins une allée froide (10, 12, 14) confinée et disposée dans une pièce chaude (40) et fluidiquement reliée via au moins un ventilateur (88, 90, 92) à une seconde chambre (44) délimitée par la paroi de délimitation (42) conçue par endroit sous forme de paroi de refroidissement, de la chambre chaude, le ventilateur étant fluidiquement relié à la chambre chaude, côté pression à au moins une allée froide et côté aspiration via au moins un échangeur de chaleur (70, 72, 74, 76, 80) formant une section de la paroi de délimitation,
**caractérisé en ce**
**que** le ventilateur (88, 90, 92) est disposé dans une ouverture (82, 84, 86) de la paroi de délimitation (42) ou est relié à cette dernière et qu'au moins une zone d'un côté d'au moins une allée froide (10, 12, 14), ou une connexion avec cette dernière, est délimitée par une section de la paroi de délimitation à l'intérieur de laquelle passe l'ouverture.

10. Dispositif selon la revendication 9,
**caractérisé en ce**
**que** l'un des côtés frontaux de l'allée froide (10, 12, 14) est délimité par la section de la paroi de délimitation (42) avec l'ouverture (82, 84, 86) débouchant dans l'allée froide.

11. Dispositif selon la revendication 9 ou 10,
**caractérisé en ce**
**que** des zones de la paroi de délimitation (42) s'étendant entre des côtés longitudinaux des allées froides adjacentes (10, 12, 14) sont constituées au moins par endroit d'un ou de plusieurs échangeurs de chaleur (70. 72, 74, 76, 78, 80).

12. Dispositif selon au moins l'une des revendications 9 à 11,
**caractérisé en ce**
**que** plusieurs ouvertures (82, 84, 86) ou ventilateurs (88, 90, 92) sont prévus à l'intérieur de la zone de paroi de délimitation (42) recouverte par l'allée froide (10, 12, 14) ou l'une des sections partant de cette dernière.

13. Dispositif selon au moins l'une des revendications 9 à 12,
**caractérisé en ce**
**que** les multiples ouvertures (82, 84, 86) sont disposées dans une rangée verticale.

14. Dispositif selon l'une des revendications 9 à 13.
**caractérisé en ce**
**que** la chambre chaude (40) est séparée de deux secondes chambres (44) par deux parois de délimitation (42), de préférence des parois de délimitation (42) opposées, qu'il y a dans chacune des parois de délimitation au moins une ouverture (82, 84, 86) avec au moins un ventilateur (25) affecté à cette dernière et que chacune des ouvertures est raccordée à au moins une allée froide (10, 12, 14), en particulier que chaque côté frontal de l'allée froide entoure respectivement l'une des ouvertures des deux parois de délimitation.
